# EUROPÄISCHE PATENTSCHRIFT

(11) **EP 0 729 619 B1**
(45) Veröffentlichungstag und Bekanntmachung des Hinweises auf die Patenterteilung: **12.02.2003**
(21) Anmeldenummer: 95900613.1
(22) Anmeldetag: 10.11.1994
(51) Int. Cl.: G06F 17/50, G06F 17/60

(54) **VERFAHREN ZUR AUTOMATISCHEN MODELLIERUNG EINES TEILPROZESSES AUS EINEM GESAMTPROZESS DURCH EINEN RECHNER**
METHOD OF AUTOMATICALLY MODELLING PART OF AN OVERALL PROCESS BY MEANS OF A COMPUTER
PROCEDE DE MODELISATION AUTOMATIQUE D'UNE PARTIE D'UN PROCESSUS GLOBAL A L'AIDE D'UN ORDINATEUR

(30) Priorität: 15.11.1993 DE 4338989
(43) Veröffentlichungstag der Anmeldung: 04.09.1996
(73) Patentinhaber: SIEMENS AKTIENGESELLSCHAFT, 80333 München (DE)
(72) Erfinder: MAIER, Rupert, D-91330 Eggolsheim (DE)
(86) Internationale Anmeldenummer: DE9401326
(87) Internationale Veröffentlichungsnummer: WO95014281

(56) Entgegenhaltungen:
- WO-A-91/17494
- IBM SYSTEMS JOURNAL, Bd.32, Nr.3, 1993, ARMONK, NEW YORK US Seiten 376 - 396 SARACELLI ET AL 'process automation in software application development'
- PROCEEDINGS FIFTH INTERNATIONAL WORKSHOP ON COMPUTER-AIDED SOFTWARE ENGINEERING, 6. Juli 1992, MONTREAL QUEBEC CANADA Seiten 142 - 155 HEYM ET AL 'a semantic data model for methodology engineering'

## Beschreibung

Engineering-Prozesse (zum Beispiel Projektierungsprozesse) werden zunehmend komplexer und unübersichtlicher. Damit sie trotzdem effektiv definiert und optimiert werden können, bedient man sich in immer größerem Maße der Modellierung. Die jeweils verwendete Methode muß dabei folgende Probleme lösen:
- Beherrschung der Komplexität
- Anpassung des Modells an unterschiedliche Fragestellungen
- Verständlichkeit der Modelle für alle Beteiligten (angemessene Darstellung des zu optimierenden Komplexes).

Die einzelnen, zu modellierenden Teile des Modells besitzen eine Vielzahl von Eigenschaften, die bei der Definition bzw. Optimierung des Prozesses berücksichtigt werden müssen (zum Beispiel verwendete Werkzeuge und Hilfsmittel, Durchlaufzeiten, Zuständigkeiten/Bearbeiter, Zusammenhänge zwischen den einzelnen Prozeßelementen, Benutzer, ...).

An solchen komplexen Prozessen bzw. an deren Optimierung sind in der Regel mehrere unterschiedliche Abteilungen, Werkzeuge und Verfahren beteiligt. Beispielsweise bei der Projektierung von Gas- und Dampfkraftwerken entstehen bis zu 15.000 Dokumente. An der Erstellung sind zum Beispiel verschiedenste Gruppen/Personen wie der Projektleiter, Projektierer der Leittechnik, der Bautechnik, aber auch Toolentwickler oder Kostenverantwortliche beteiligt. Aufgrund der unterschiedlichen Interessenschwerpunkte besitzen die beteiligten Gruppen verschiedene Fragestellungen zu einzelnen Details des Prozesses. Beim Austausch des Typs einer Kühlkreislaufpumpe während eines Projektierungsprozesses stellen sich zum Beispiel folgende Fragen:

Wie entwickeln sich die Kosten unter Berücksichtigung sämtlicher Folgeaktivitäten? Oder: Welche baulichen Änderungen sind dadurch nötig?

Je nach Interessenschwerpunkt und Aufgabenbereich der einzelnen Gruppen ergeben sich weitere unterschiedliche Fragestellungen die durch ein Prozessmodell beantwortet und für alle Beteiligten übersichtlich und verständlich dargestellt werden müssen.

Derzeit gibt es punktuelle Lösungsansätze (Insellösungen) zur Optimierung einzelner Teile von Engineering-Prozessen. Trotzdem sind die Ausschnitte der Prozesse immer sehr komplex, so dass man ohne geeignete Strukturierung sehr schnell den Überblick verlieren kann. Doch gerade die Möglichkeiten der flexiblen Strukturierung, unter Benutzung sich ändernder Anforderungen sind bei bisher verfügbaren Werkzeugen und Modellierungsmöglichkeiten nicht vorgesehen. Deshalb bereitet auch die Beherrschung der Gesamtkomplexität beim Engineering großer Anlagen, aber auch bei großen Systementwicklungen immer noch große Schwierigkeiten. Besonders schwierig ist es dabei den Informationsfluss der zwischen den einzelnen Beteiligten erforderlich ist zu erfassen bzw. zu optimieren. Bisher bekannte Modellierungsmöglichkeiten, beispielsweise aus WO-A-91 17494, sind die strukturierte Analyse, die Darstellung in Entity-Relationship-Modellen, oder SDL-Modellen. Um die Komplexität eines Engineering-Prozesses beherrschen zu können wird bei den gängigen Methoden beispielsweise eine wichtige Eigenschaft/Kenngröße (zum Beispiel die funktionellen Abhängigkeiten) der zu modellierenden Teile herausgegriffen. Gemäß dieser Kenngröße wird ein starre Hierarchie aufgebaut und das Modell dementsprechend strukturiert. Diese Vorgehensweise hat jedoch zur Folge, dass Zusammenhänge die sich bei der Berücksichtigung anderer Kenngrößen ergeben würden nicht ausreichend berücksichtigt werden. Auch ist die notwendige Struktur nicht in jedem Fall zu Beginn der Modellierung bekannt. So wird zunächst eine Stoffsammlung durchgeführt und erst nachträglich in mehreren Iterationsschritten ein Hierarchiebaum gefunden. Diese einmal gefundene und zugrundegelegte Hierarchiestruktur ist starr und ermöglicht nur die Beantwortung weniger Fragestellungen. Die Information zur Beantwortung weiterer Fragestellungen ist entweder über das gesamte Modell verteilt oder nicht im Modell enthalten da keine Unterstützung existiert um Daten sinnvoll einzugeben oder wieder auszulesen respektive das Modell erweitern zu können. Ein weiteres Problem stellt die Verständlichkeit der Modelle der einzelnen jeweiligen Modellierungsmethoden dar. Die bisherigen Ansätze sind sehr stark auf einzelnen Betroffene (zum Beispiel Entwickler und DV-Experten) ausgelegt.

An der Definition bzw. Optimierung des Prozesses sind aber in der Regel weitere Personen wie Projektleiter, Entscheider und Außenstehende beteiligt. Die Modelle sind für diese Personenkreise zu wenig verständlich und beantworten deren Fragen nur unbefriedigend, daher finden sie nur bedingt Akzeptanz.

Die der Erfindung zugrundeliegende Aufgabe besteht darin, ein Verfahren anzugeben, mit dem es möglich ist, in Abhängigkeit einer speziellen Fragestellung ein Prozeßmodell aus einem Gesamtmodell automatisch zu erzeugen.

Diese Aufgabe wird gemäß den Merkmalen des Patentanspruchs 1 gelöst.

Weiterbildungen der Erfindung ergeben sich aus den Unteransprüchen.

Ein großer Vorteil des erfindungsgemäßen Verfahrens ist die Verwendung von lediglich zwei Grundelementen zur Modellierung auch komplexer Gesamtprozesse. Damit wird der Gesamtprozeß sehr detailliert dargestellt aber dies führt auch dazu, daß der automatisch modellierte Teilprozeß sehr leicht verständlich ist, lediglich die nötigen Informationen enthält und anschaulich dargestellt werden kann. Die unterschiedlichen Fragestellungen der einzelnen Prozeßbeteiligten werden auf vorteilhafte Weise durch die Zuordnung von Attributen zu Ergebnissen und Tätigkeiten, den Modellbestandteilen, ermöglicht. So kann auf vorteilhafte Weise aus einem komplexen Gesamtprozeß in Abhängigkeit von verschiedensten vorher eingegebenen Attributen ein ganz spezieller Teilprozeß, der nur die spezielle Problematik berücksichtigt, automatisch modelliert werden.

Vorteilhaft werden bei dem erfindungsgemäßen Verfahren mehrere Teilergebnisse, welche die Voraussetzungen für eine Teiltätigkeit liefern, in einem Informationsknoten zusammengefaßt. Dies erleichtert die Übersichtlichkeit des automatisch modellierten Prozesses.

Durch die logische Verknüpfung einzelner Attribute miteinander wird günstigerweise erreicht, daß auch sehr komplexe Zusammenhänge aus einem Gesamtprozeß herausgefiltert und in einem modellierten Teilprozeß dargestellt werden können.

Durch die erfindungsgemäße Darstellung von Attributen als Zahlen und Texten kann vorteilhaft erreicht werden, daß beispielsweise auch Durchlaufzeituntersuchungen bzw. Kostenanalysen bei der Modellierung eines Teilprozesses eine Rolle spielen können.

Mit der wählbaren Vorgabe von Attributen für die Modellierung des Gesamtprozesses wird günstigerweise erreicht, daß die Konsistenz des Gesamtprozeßmodells erhalten bleibt. Denn es ist beispielsweise denkbar, daß einzelne Abteilungen welche am Gesamtprozeß beteiligt sind, ihren Bereich separat modellieren und diese einzelnen Modelle zu einem Gesamtprozeß zusammengefügt werden.

Durch die hierarchische Ordnung der Attribute kann man vorteilhaft erreichen, daß automatisch modellierte Prozesse noch genauer auf eine Fragestellung ausgerichtet sein können, ohne daß dabei die Übersichtlichkeit leidet.

Die Darstellung von Ergebnissen als markierte Flächen und Tätigkeiten als Pfeile erleichtert die Übersichtlichkeit des automatisch erstellten Teilprozesses.

Im folgenden wird die Erfindung anhand von Figuren weiter erläutert.
- Figur 1: zeigt dabei Beispiele für Ergebnis- und Tätigkeitsattribute.
- Figur 2: zeigt ein Beispiel für einen Informationsknoten.
- Figur 3: zeigt ein Beispiel eines automatisch modellierten Teilprozesses.
- Figur 4: zeigt ein Beispiel eines Entity-Relationshipmodelles für das erfindungsgemäße Verfahren.

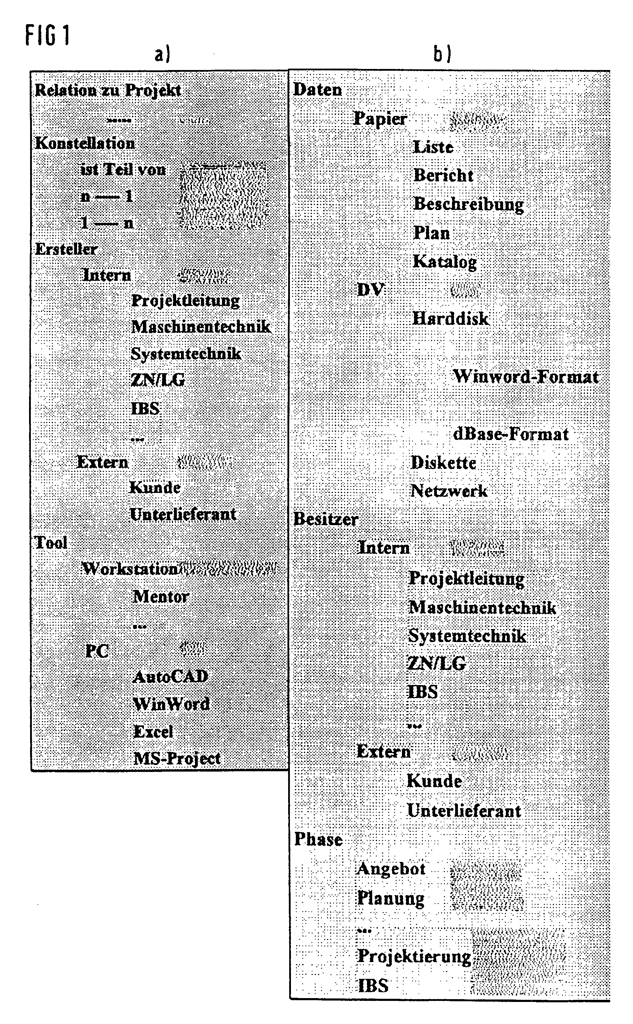

In Figur 1 sind hierarchisch gegliederte Beispiele von Tätigkeitsattributen und Ergebnisattributen dargestellt. Hierbei zeigt Figur 1a die Tätigkeitsattribute und Figur 1b die Ergebnisattribute. Diese Merkmale können beispielsweise aus folgenden Gründen in Strukturbäumen hinterlegt sein:
- Der Modellersteller hat die Merkmale nach ihm wichtig erscheinenden Kriterien strukturiert.
- Die Struktur erleichtert das Auffinden der einzelnen Merkmale bei der Modellerstellung , bzw. bei der automatischen Modellierung des Teilprozesses.
- Eine Affinität zwischen Ergebnis und Tätigkeitsattributen kann in der Struktur dargestellt sein, indem verwandte Attribute sich in den entsprechenden Zweigen eines Strukturbaumes wiederfinden.

Beispielsweise können solche Attributenbäume vor oder während der Modellerstellung definiert und modifiziert werden. Bei der Definition kann auch beispielsweise festgelegt werden wieviele Textattribute aus den einzelnen Bäumen je Ergebnis bzw. Tätigkeit auszuwählen sind. Hierzu können folgende Möglichkeiten vorgesehen sein:
1. Genau ein Element des Baumes (zum Beispiel beim Attributebaum des Ablageformats eines Ergebnisses).
2. Höchstens ein Element des Baumes.
3. Mindestens ein Element des Baumes (zum Beispiel beim Attributebaum der "Durchführenden" einer Tätigkeit).
4. Beliebig viele Elemente (zum Beispiel "verwendete Werkzeuge" bei der Durchführung einer Tätigkeit).

Es kann auch vorgesehen sein, daß für neu einzugebende bzw. sich ändernde Teile eines Gesamtmodells ein Plausibilitätstest stattfindet. Hierbei kann beispielsweise überprüft werden, ob die Ergebnisse und Tätigkeiten mit den geforderten Attributen belegt wurden. Bei einer Änderung und Neuerstellung von Attributebäumen ist ein Plausibilitätstest beispielsweise auch für bereits eingegebene Modellteile erforderlich. Implizit können beispielsweise Tätigkeitsattribute zusammengefaßt sein. Dabei werden beispielsweise die tiefsten Verzweigungspunkte eines Baumes als Attribute der Tätigkeit angezeigt unter denen alle ausgewählten Attribute eines Baumes liegen. Es kann auch vorgesehen sein, Ergebnisattribute implizit zusammenzufassen wenn Ergebnisse bezüglich einer Und-Gruppe zusammengefaßt werden. Beispielsweise können alle Attribute die jene Ergebnisse zusätzlich charakterisieren in einer Baumstruktur zusammengefaßt werden. Jedoch hat die Baumstruktur keinen Einfluß auf eine logische Oder-Verknüpfung von Attributen. In Figur 1a sind beispielsweise unterschiedliche Tätigkeitsattribute dargestellt wie "Relation zu Projekt" und "Konstellation". Von "Konstellation" sind Unterattribute "ist Teil von" und weiterhin "Ersteller". Ist dieser Ersteller "Intern" wo ist der Ersteller organisatorisch angesiedelt? Ist er "Extern"? Beispielsweise ist ein weiterer Verzweigungspunkt des Attributebaumes "Tool" deren Unterattribut "Workstation" ist, wobei ein "Tool" wiederum "Mentor" als Unterattribut darstellt. Ein weiteres Unterattribut von "Tool" kann auch "PC" sein auf dem entsprechende Software als Unterattribut ausgeführt werden kann.

Figur 1b zeigt Beispiele von Ergebnisattributen. Beispielsweise kann ein Ergebnisattribut "Daten" sein. Diese Daten können sich unterverzweigen in "Papier" oder "Datenverarbeitung", wobei sich Papier wiederum unterverzweigen kann in Listen, "Berichte", "Beschreibungen", "Pläne" und "Kataloge" und die "Datenverarbeitung" weiter in einer "Harddisc" welche in unterschiedlichen Formaten beschrieben sein kann. Zum Beispiel gibt es auch eine "Diskette" bzw. ein Netzwerk als Unterattribut von "DV". Weiterhin ist beispielsweise "Besitzer" ein Ergebnisattribut welcher "Intern" oder "Extern" angesiedelt sein kann. Weiterhin kann beispielsweise auch eine "Projektphase" als Ergebnisattribut vorgesehen sein, wobei sich diese unteraufspalten kann in "Angebot", "Planungs-" und "Projektierungsphase".

Die vorgestellten Attributebäume sind nur als Beispiele anzusehen. Es ist je nach Abhängigkeit eines Gesamtprozesses eine sinnvolle Attributeauswahl vorzugeben und diese bei der Modellierung zu verwenden. In Abhängigkeit der vorgegebenen Attribute kann anschließend ein Teilprozeß automatisch modelliert werden.

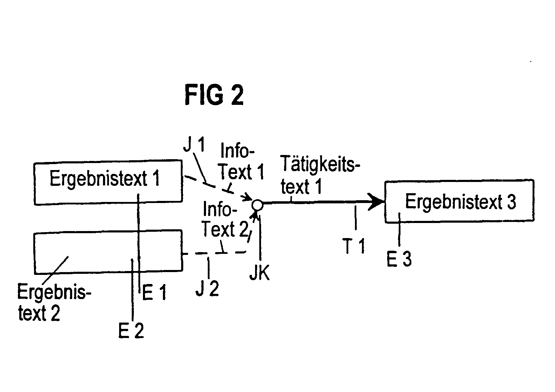

Figur 2 zeigt beispielhaft wie mit dem erfindungsgemäßen Verfahren Informationen , die bei Teilergebnissen anfallen und Voraussetzung für eine Teiltätigkeit sind dargestellt werden können.

In Figur 2 sind drei Teilergebnisse dargestellt, die mit E1 bis E3 bezeichnet sind. Weiterhin ist ein Informationsknoten IK und Textinformationen E1 und E2 zu sehen. Vom Informationsknoten IK geht eine Teiltätigkeit T1 zum Ergebnis E3.

Da laut der Definition des erfindungsgemäßen Verfahrens nur Ergebnisse über Tätigkeiten in Ergebnisse überführt werden sieht es das erfindungsgemäße Verfahren günstigerweise vor, daß falls mehrere Ergebnisse Informationen bereitstellen, welche Grundlage für eine Teiltätigkeit sind, diese Informationen aus den Ergebnissen extrahiert werden. Hier beispielsweise I1 und I2 aus den Ergebnissen E2 und E1. Diese Informationen werden dann in einem Informationsknoten zusammengefaßt, welcher dann praktisch als Ergebnis im Sinne des erfindungsgemäßen Verfahrens gilt und von einer Teiltätigkeit hier T1 in ein weiteres Teilergebnis des erfindungsgemäßen Verfahrens überführt wird. Dieses Teilergebnis ist in Figur 2 mit E3 bezeichnet.

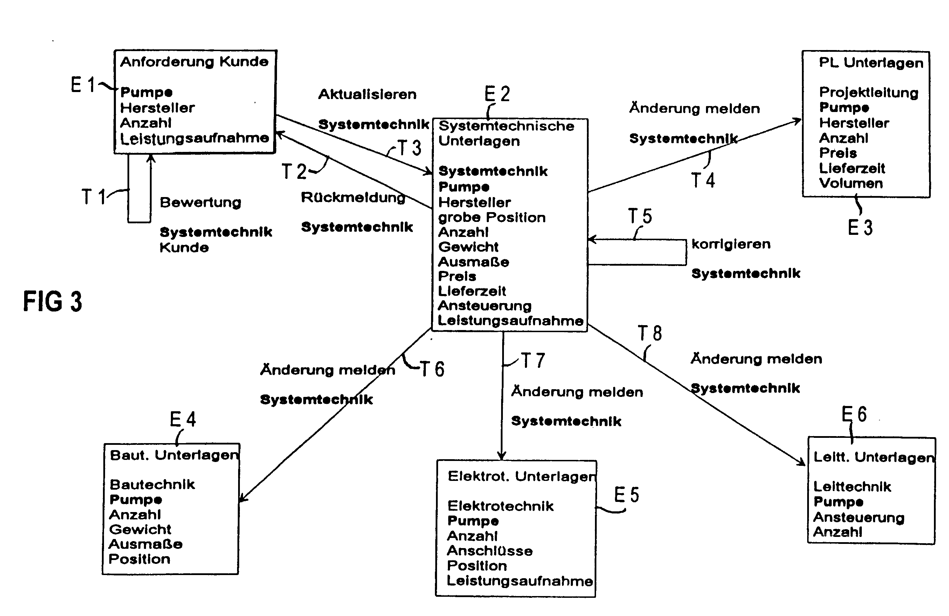

Figur 3 zeigt einen Teilprozeß der nach dem erfindungsgemäßen Verfahren automatisch generiert wird. Die Teilergebnisse sind in Figur 3 in Rechtecken dargestellt, welche von E1 bis E6 bezeichnet sind. Diese einzelnen Rechtecke bzw. Teilergebnisse werden über Teiltätigkeiten T1 bis T8 ineinander überführt. Figur 3 liegt folgende Ausgangssituation zugrunde. Hier soll beispielsweise festgestellt werden, welche Abteilungen bzw. welche Fertigungsvorgänge davon betroffen sind, falls bei der Fertigungsvorbereitung festgestellt wird, daß ein bestimmtes Pumpenmodell nicht optimal bearbeitet werden kann und deshalb ein anderer Pumpentyp gewählt werden muß. Die organisatorische Abteilung welche diese Entscheidung trifft ist die Systemtechnik. Es werden nun als Vorgabe für das erfindungsgemäße Verfahren Ergebnisattribute Systemtechnik und Pumpe logisch verknüpft dem Rechner vorgegeben.

Weiterhin wird nun das Tätigkeitsattribut Systemtechnik ausgewählt um feststellen zu können, welche Tätigkeiten von der Systemtechnik erforderlich sind um die Änderung des Pumpentyps den Betroffenen mitzuteilen.

Zunächst muß die getroffene Änderung aus der Sicht des Kunden bewertet werden. Dies geschieht in E1 mit der Tätigkeit T1. Anschließend erfolgt eine Meldung an die Systemtechnik T3 das ein anderes Pumpenmodell verwendet werden soll. In E2 wird dann über die Tätigkeit T5 das entsprechende Pumpenmodell korrigiert und es erfolgt eine Rückmeldung T2 an die Kundenanforderungen E1. Von E2 wird dann die Tätigkeit T4 angestoßen, welche eine Änderung der Projektunterlagen in E3 veranlaßt. Weiterhin wird das geänderte Pumpenmodell über T6 den bautechnischen Unterlagen mitgeteilt, welche sich in E4 befinden. Ebenso sind die elektrotechnischen Unterlagen E5 über T7 zu ändern und die leittechnischen Unterlagen, das heißt die Terminplanung, über T8 in E6 zu korrigieren.

Dieser Teilprozeß wird automatisch aus einem Gesamtprozeß in einem erfindungsgemäßen Verfahren auf Basis der eingegebenen Attribute Systemtechnik und Pumpe als Und-Verknüpfung generiert. So wird durch das erfindungsgemäße Verfahren automatisch die Konsistenz des Fertigungsprozesses sichergestellt und ein hohes Maß an Übersichtlichkeit gewahrt.

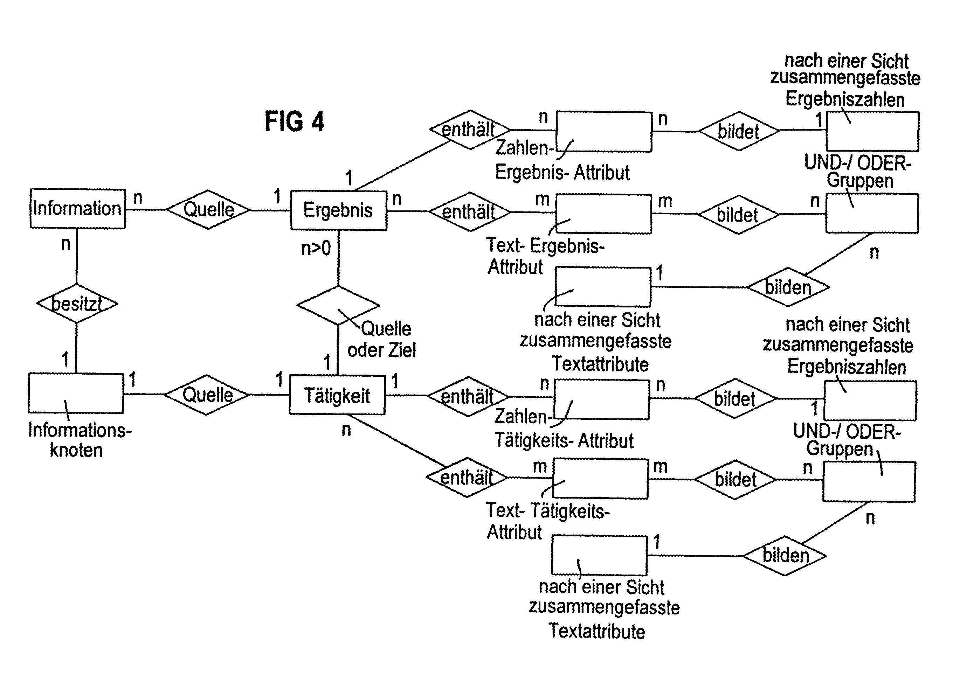

Figur 4 zeigt als Beispiel das Entity Relationship-Modell des erfindungsgemäßen Verfahrens (datentechnische Abhängigkeiten). Es ist von links nach recht zu lesen und nach dem bekannten Standard (Peter Chen: The Entity-Relationship Model, Toward a Unified View of Data, ACM Transactions on Database Systems, Vol 1, 1976) formuliert.

## Patentansprüche

1. Verfahren zur automatischen Modellierung eines Teilprozesses aus einem Gesamtprozess eines technischen Systems durch einen Rechner,
a) bei dem zur Modellierung des Gesamtprozesses Teilergebnisse (E) und Teiltätigkeiten (T) des Gesamtprozesses verwendet werden,
b) bei dem eine Teiltätigkeit (T) mit mindestens einem Tätigkeitsattribut (Tool) versehen wird,
c) bei dem ein Teilergebnis (E) mit mindestens einem Ergebnisattribut (Harddisk) versehen wird,
d) bei dem zwei Teilergebnisse (E1, E2, E3) durch eine Teiltätigkeit (T1) ineinander überführt werden,
**dadurch gekennzeichnet, dass**
der Teuprozess vom Rechner in Abhängigkeit von mindestens einem Tätigkeitsattribut und/oder Ergebnisattribut automatisch modelliert wird, indem Tätigkeitsattribute und/oder Ergebnisattribute zur Modellierung des Teilprozesses logisch verknüpft werden.

2. Verfahren nach Anspruch 1, bei dem falls mehrere Teilergebnisse (E1, E2) Voraussetzung für eine Teiltätigkeit (T1) sind, diese in einem Informationsknoten (IK) zusammengefaßt werden, welcher dann durch die Teiltätigkeit (T1) in ein Teilergebnis (E3) überführt wird.

3. Verfahren nach einem der obigen Ansprüche, bei dem ein Attribut einen Text oder eine Zahl darstellt.

4. Verfahren nach einem der obigen Ansprüche, bei dem zur Modellierung des Gesamtprozesses Attribute wählbar vorgegeben werden.

5. Verfahren nach Anspruch 4, bei dem Attribute hierarchisch geordnet werden, so daß in Abhängigkeit eines übergeordneten Attributes ein Teilprozess gröber modelliert wird.

6. Verfahren nach einem der Ansprüche 4 bis 5, bei dem mindestens zwei Gesamtprozesse, zu deren Modellierung gemeinsame Attribute verwendet wurden einen neuen Gesamtprozess bilden.

7. Verfahren nach einem der obigen Ansprüche, bei dem ein Teilergebnis (E) graphisch durch eine markierte Fläche und eine Teiltätigkeit (T) graphisch durch einen Verbindungspfeil dargestellt wird.

8. Verfahren nach Anspruch 7, bei dem die graphische Darstellung des modellierten Teilprozesses automatisch anhand der markierten Flächen, der zugrundeliegenden Attribute und einer verfügbaren Darstellungsfläche erstellt wird.

## Claims

1. Method for automatically modelling a subprocess from an overall process of a technical system by means of a computer,
a) in which for the purpose of modelling the overall process use is made of partial results (E) and sub-activities (T) of the overall process,
b) in which a subactivity (T) is provided with at least one activity attribute (tool),
c) in which a partial result (E) is provided with at least one result attribute (hard disk),
d) in which two partial results (E1, E2, E3) are converted into one another by means of a subactivity (T1), **characterized in that** the subprocess is modelled automatically by the computer as a function of at least one activity attribute and/or result attribute, by logically combining activity -attributes and/or result attributes for the purpose of modelling the subprocess.

2. Method according to Claim 1, in which if a plurality of partial results (E1, E2) are a precondition for a subactivity (T1), they are combined in an information node (IK) which is then converted into a partial result (E3) by the subactivity (T1).

3. Method according to one of the preceding claims, in which an attribute represents a text or a number.

4. Method according to one of the preceding claims, in which attributes are selectably prescribed for the purpose of modelling the overall process.

5. Method according to Claim 4, in which attributes are ordered hierarchically so that a subprocess is modelled more coarsely as a function of a higher-order attribute.

6. Method according to one of Claims 4 to 5, in which at least two overall processes, for the modelling of which common attributes have been used, form a new overall process.

7. Method according to one of the preceding claims, in which a partial result (E) is represented graphically by means of a marked surface, and a subactivity (T) is represented graphically by means of a connecting arrow.

8. Method according to Claim 7, in which the graphical representation of the modelled subprocess is created automatically with the aid of the marked surfaces, the basic attributes and an available representing surface.

## Revendications

1. Procédé de modélisation automatique d'une partie d'un processus global d'un système technique à l'aide d'un ordinateur,
a) dans lequel on utilise des résultats partiels (E) et des actions partielles (T) du processus global pour la modélisation du processus global,
b) dans lequel une action partielle (T) est munie au moins d'un attribut d'action (Tool),
c) dans lequel un résultat partiel (E) est muni au moins d'un attribut de résultat (Harddisk),
d) dans lequel deux résultats partiels (E1, E2, E3) sont transformés l'un dans l'autre par une action partielle (T1)
**caractérisé en ce que** le processus partiel est modélisé automatiquement par l'ordinateur en fonction d'au moins un attribut d'action et/ou attribut de résultat, par l'enchaînement logique des attributs d'action et/ou des attributs de résultat pour la modélisation du processus partiel.

2. Procédé selon la revendication 1, dans lequel, au cas où plusieurs résultats partiels (E1, E2) sont la condition d'une action partielle (T1), ceux-ci sont regroupés dans un noeud d'information (IK), lequel est alors transformé en un résultat partiel (E3) par l'action partielle (T1).

3. Procédé selon l'une quelconque des revendications précédentes, dans lequel un attribut représente un texte ou un chiffre.

4. Procédé selon l'une quelconque des revendications précédentes, dans lequel des attributs sont préfédinis au choix pour la modélisation du processus global.

5. Procédé selon la revendication 4, dans lequel des attributs sont classés de manière hiérarchique, de sorte qu'un processus partiel est modélisé de manière plus grossière en fonction d'un attribut prioritaire.

6. Procédé selon l'une quelconque des revendications 4 à 5, dans lequel au moins deux processus globaux, dont des attributs communs ont été utilisés pour leur modélisation, forment un nouveau processus global.

7. Procédé selon l'une quelconque des revendications précédentes, dans lequel un résultat partiel (E) est représenté graphiquement par une surface marquée et dans lequel une action partielle (T) est représentée graphiquement par une flèche de liaison.

8. Procédé selon la revendication 7, dans lequel la représentation graphique du processus partiel modélisé est créée automatiquement à l'aide des surfaces marquées, des attributs fondamentaux et d'une surface de représentation disponible.
